# EUROPÄISCHE PATENTSCHRIFT

(11) **EP 2 918 778 B1**
(45) Veröffentlichungstag und Bekanntmachung des Hinweises auf die Patenterteilung: **11.12.2019**
(21) Anmeldenummer: 15153431.0
(22) Anmeldetag: 02.02.2015
(51) Int. Cl.: F01D 5/10, G06F 17/50, F01D 5/16

(54) **VERFAHREN ZUM AUSLEGEN EINER TURBINE**
METHOD FOR LAYING OUT A TURBINE
PROCÉDÉ DE DIMENSIONNEMENT D'UNE TURBINE

(30) Priorität: 14.03.2014 DE 102014204725
(43) Veröffentlichungstag der Anmeldung: 16.09.2015
(73) Patentinhaber: MTU Aero Engines AG, 80995 München (DE)
(72) Erfinder: Broszat, Dominik, 85521 Riemerling (DE); Thouault, Nicolas, 81247 München (DE)

(56) Entgegenhaltungen:
- WO-A1-2013/186756
- US-A1- 2011 123 342
- US-A1- 2012 099 995
- US-A1- 2014 050 590

## Beschreibung

Die vorliegende Erfindung betrifft ein Verfahren zum Auslegen einer Turbine, insbesondere einer Niederdruckturbine, einer Gasturbine, insbesondere eines Flugtriebwerks sowie eine entsprechend ausgelegte Turbine.

Aus dem eigenen europäischen Patent EP 1 738 061 B1 und dem parallelen eigenen US-Patent US 7,806,651 B2, auf die Bezug genommen wird, ist ein Verfahren zum Auslegen einer Turbine nach dem Oberbegriff des Anspruchs 1 bzw. eine Turbine nach dem Oberbegriff des Anspruchs 9 bekannt.

Dieses Patent schlägt vor, wenigstens eine Stufe der Turbine derart auszulegen, dass eine Kenngröße vane-to-blade-ratio, die das Verhältnis von der Leitschaufelanzahl zu der Laufschaufelanzahl der Stufe angibt, in lärmkritischen Betriebsbedingungen der Turbine zwischen einer unteren cut-off Grenze für die Mode k=-1 der blade-passing-frequency dieser Stufe und einer oberen cut-off Grenze für die Mode k=-2 der blade-passing-frequency dieser Stufe liegt, um den von der Turbine abgestrahlten Lärmpegel zu reduzieren.

Die US 2011/0123342 A1 offenbart ein Verfahren zum Herstellen eines Verdichterabschnitts, wobei Leit- und Laufschaufelzahlen gemäß einer cut-off-Auslegung ausgewählt werden.

Die US 2012/099995 A1 offenbart eine Turbomaschine mit voneinander verschiedenen Schaufelabständen.

Die WO 2013/186756 A1 offenbart Schaufelanordnungen mit voneinander verschiedenen geometrischen Merkmalen. Aus der US2014/0050590A1 ist ein Laufgitter mit verschiedenen Schaufeln bekannt.

Eine Aufgabe einer Ausführung der vorliegenden Erfindung ist es, eine Turbine einer Gasturbine zu verbessern.

Diese Aufgabe wird durch ein Verfahren mit den Merkmalen des Anspruchs 1 gelöst. Anspruch 9 stellt eine entsprechende Turbine unter Schutz. Vorteilhafte Ausführungsformen der Erfindung sind Gegenstand der Unteransprüche.

Nach einem Aspekt der vorliegenden Erfindung weist eine auszulegende oder ausgelegte Turbine einer Gasturbine mehrere in Durchströmungsrichtung der Turbine axial hintereinander angeordnete Stufen auf, die jeweils von einem feststehenden, mehrere Leitschaufeln aufweisenden Leitgitter und einem rotierenden, mehrere Laufschaufeln aufweisenden Laufgitter gebildet sind, welches in Durchströmungsrichtung stromabwärts oder stromaufwärts dem Leitgitter der Stufe benachbart sein kann. Das Leitgitter einer Stufe kann also gleichermaßen das Eintrittsleitgitter dieser Stufe oder das Austrittsleitgitter dieser Stufe bzw. das Eintrittsleitgitter einer in Durchströmungsrichtung stromabwärts benachbarten weiteren Stufe sein.

Die Turbine kann insbesondere eine ein- oder mehrstufige Niederdruckturbine sein, die in Durchströmungsrichtung stromabwärts nach einer ein- oder mehrstufigen Hoch- oder Mitteldruckturbine und/oder stromaufwärts vor einem Turbinenaustrittsgehäuse ("turbine exit case" TEC) angeordnet sein kann. Die Gasturbine kann insbesondere eine Flugtriebwerk-Gasturbine sein. Sie weist in einer Ausführung eine der Turbine vorgeschaltete Brennkammer und eine oder mehrere dieser Brennkammer vorgeschaltete ein- oder mehrstufige Verdichter auf. Das Flugtriebwerk kann insbesondere einen Fan aufweisen, der, insbesondere über ein Getriebe, mit der Niederdruckturbine gekoppelt sein kann.

Nach einem Aspekt der vorliegenden Erfindung weist das Laufgitter einer oder mehrerer Stufen der auszulegenden bzw. ausgelegten Turbine jeweils eine Mehrzahl von Laufschaufelanordnungen auf, in einer Ausführung wird bzw. ist das Laufgitter von der Mehrzahl von Laufschaufelanordnungen gebildet bzw. weist außer den Laufschaufeln der Laufschaufelanordnungen keine weiteren Laufschaufeln auf.

Die Stufe kann eine in Durchströmungsrichtung stromaufwärts vor einer weiteren Stufe angeordnete, insbesondere erste, Stufe oder eine in Durchströmungsrichtung stromabwärts nach einer weiteren Stufe angeordnete, insbesondere letzte, Stufe der Turbine sein. Die Laufschaufelanordnungen der Stufe sind in einer Ausführung untereinander gleich.

Die Laufschaufelanordnungen sind in einer Ausführung jeweils von wenigstens zwei Laufschaufeln mit voneinander verschiedenen Schaufelprofilen gebildet. Voneinander verschiedene Schaufelprofile können insbesondere unterschiedliche Profildicken, Profildickenverteilungen, Twist- und/oder Staffelungsverteilungen und/oder Profiltypen aufweisen. Zusätzlich oder alternativ sind die Laufschaufelanordnungen in einer Ausführung jeweils von wenigstens zwei Laufschaufeln mit voneinander verschiedenen Schaufelabständen zu in Rotationsrichtung nachfolgend benachbarten Laufschaufeln gebildet. Die Laufschaufeln einer Laufschaufelanordnung können miteinander lösbar oder dauerhaft verbunden, insbesondere integral miteinander ausgebildet werden bzw. sein.

Durch solche periodisch aufeinanderfolgende Laufschaufelanordnungen treten neben der blade-passing-frequency und deren Harmonischen, die in dem einleitend erläuterten europäischen Patent EP 1 738 061 B1 betrachtet werden, zusätzlich auch akustische Beiträge bei (niedrigeren) Frequenzen entsprechend der Periodizität der Umfangsverteilung der Laufschaufelanordnungen auf. So tritt beispielsweise bei einer Stufe, deren Laufgitter ABABAB... aus abwechselnd angeordneten Schaufeln A, B, d.h. aus untereinander gleichen Laufschaufelanordnungen (AB) gebildet ist, ein akustischer Beitrag bei der halben Blattfolgefrequenz sowie deren Harmonischen auf.

Indem (auch oder nur) solche akustischen Beiträge in einem cut-off-Bereich platziert werden, kann vorteilhaft ein von der Turbine abgestrahlter Geräuschpegel verbessert werden.

Eine Stufe mit einer Mehrzahl von Laufschaufelanordnungen mit jeweils wenigstens zwei Laufschaufeln mit verschiedenen Schaufelprofilen und/oder Schaufelabständen zu in Rotationsrichtung nachfolgend benachbarten Laufschaufeln ist durch eine Kenngröße vane-to-blade-cluster-ratio V/(B/P) charakterisiert, die das Verhältnis von der Leitschaufelanzahl V zu dem Quotienten (B/P) der Laufschaufelanzahl B der Stufe dividiert durch die Laufschaufelanzahl P pro Laufschaufelanordnung angibt. P entspricht damit einer Periodizität der Umfangsverteilung der Laufschaufelanordnungen. Wenn die Laufschaufelanordnungen der Stufe unterschiedliche Laufschaufelanzahlen aufweisen, kann die Laufschaufelanzahl P pro Laufschaufelanordnung im Sinne der vorliegenden Erfindung die maximale, minimale oder gemittelte bzw. durchschnittliche Laufschaufelanzahl pro Laufschaufelanordnung sein.

Sind bzw. werden beispielsweise in einer Ausführung alle Laufschaufelanordnungen, die eine Stufe bilden, durch jeweils eine erste Laufschaufel A und eine zweite Laufschaufel B gebildet, die ein von der ersten Schaufel A verschiedenes Schaufelprofil und/oder einen von der ersten Schaufel A verschiedenen Schaufelabstand zu einer in Rotationsrichtung nachfolgend benachbarten Laufschaufeln aufweist, so weist diese Stufe die Form (AB)(AB)(AB)... und eine Periodizität bzw. Laufschaufelanzahl P pro Laufschaufelanordnung von 2 auf.

Sind bzw. werden hingegen beispielsweise in einer anderen Ausführung alle Laufschaufelanordnungen, die eine Stufe bilden, durch jeweils eine erste Laufschaufel A, eine zweite Laufschaufel B, die ein von der ersten Schaufel A verschiedenes Schaufelprofil und/oder einen von der ersten Schaufel A verschiedenen Schaufelabstand zu einer in Rotationsrichtung nachfolgend benachbarten Laufschaufeln aufweist, und eine weitere erste Laufschaufel A oder eine dritte Laufschaufel C gebildet, die ein von der ersten Schaufel A und zweiten Schaufel B verschiedenes Schaufelprofil und/oder einen von der ersten Schaufel A und zweiten Schaufel B verschiedenen Schaufelabstand zu einer in Rotationsrichtung nachfolgend benachbarten Laufschaufel aufweist, so weist diese Stufe die Form (ABA)(ABA)(ABA)... bzw. (ABC)(ABC)(ABC)... und eine Periodizität bzw. Laufschaufelanzahl P pro Laufschaufelanordnung von 3 auf.

Nach einem Aspekt der vorliegenden Erfindung wird nun diese Stufe derart ausgelegt, dass diese Kenngröße vane-to-blade-cluster-ratio in einer vorgegebenen Betriebsbedingung der Turbine über einer oberen cut-off Grenze für die Mode k=-1 oder zwischen einer unteren cut-off Grenze für die Mode k=-1 und einer oberen cut-off Grenze für die Mode k=-2 bei einer Frequenz f/P gebildet aus dem Verhältnis der blade-passing-frequency f zu der Laufschaufelanzahl pro Laufschaufelanordnung P oder einem ganzzahligen Vielfachen 2·(f/P), 3·(f/P),... dieses Verhältnisses, insbesondere dem Doppelten oder Dreifachen dieses Verhältnisses, liegt.

Durch diese Platzierung eines akustischen Beitrags bei der (niedrigeren) Frequenz entsprechend der Periodizität der Umfangsverteilung der Laufschaufelanordnungen in einem cut-off-Bereich kann, wie vorstehend erläutert, vorteilhaft ein von der Turbine abgestrahlter Geräuschpegel verbessert werden.

Die vorgegebene Betriebsbedingung kann insbesondere eine lärmkritische Betriebsbedingung sein, wie sie in dem einleitend erläuterten europäischen Patent EP 1 738 061 B1 betrachtet wird, insbesondere ein Startvorgang, ein Landeanflug und/oder ein Rollen auf einem Rollfeld eines Flugzeugs mit der Turbine.

Die blade-passing-frequency bzw. Blattfolgefrequenz bezeichnet in an sich bekannter Weise die Frequenz, mit der die rotierenden Laufschaufeln an einer feststehenden Leitschaufel der Stufe vorbei rotieren.

In einer Ausführung werden bzw. sind die Laufschaufelanordnungen der Stufe jeweils von genau zwei Laufschaufeln gebildet, die voneinander verschiedene Schaufelprofile und/oder voneinander verschiedene Schaufelabstände zu in Rotationsrichtung nachfolgend benachbarten Laufschaufeln aufweisen. Insbesondere weist in einer Ausführung diese Stufe die Form (AB)(AB)(AB)... und eine Periodizität bzw. Laufschaufelanzahl P pro Laufschaufelanordnung von 2 auf.

In einer anderen Ausführung werden bzw. sind die Laufschaufelanordnungen der Stufe jeweils von wenigstens, insbesondere genau drei Laufschaufeln gebildet, von denen zwei oder alle paarweise voneinander verschiedene Schaufelprofile und/oder voneinander verschiedene Schaufelabstände zu in Rotationsrichtung nachfolgend benachbarten Laufschaufeln aufweisen. Insbesondere können die Laufschaufelanordnungen dieser Stufe jeweils eine erste Schaufel A, eine dieser in Rotationsrichtung nachfolgend benachbarte zweite Laufschaufel B und eine dieser in Rotationsrichtung nachfolgend benachbarte weitere erste Laufschaufel A oder dritte Laufschaufel C aufweisen, insbesondere durch diese gebildet sein, wobei erste, zweite und dritte Laufschaufeln voneinander verschiedene Schaufelprofile und/oder voneinander verschiedene Schaufelabstände zu in Rotationsrichtung nachfolgend benachbarten Laufschaufeln aufweisen. Dann kann diese Stufe insbesondere die Form (ABA)(ABA)(ABA)... oder (ABC)(ABC)(ABC)... und eine Periodizität bzw. Laufschaufelanzahl P pro Laufschaufelanordnung von 3 aufweisen.

In einer Ausführung werden bzw. sind die Laufschaufelanordnungen der Stufe jeweils von wenigstens, insbesondere genau vier Laufschaufeln gebildet, von denen zwei, drei oder alle paarweise voneinander verschiedene Schaufelprofile und/oder voneinander verschiedene Schaufelabstände zu in Rotationsrichtung nachfolgend benachbarten Laufschaufeln aufweisen. Insbesondere können die Laufschaufelanordnungen dieser Stufe jeweils eine erste Schaufel A, eine dieser in Rotationsrichtung nachfolgend benachbarte zweite Laufschaufel B, eine dieser in Rotationsrichtung nachfolgend benachbarte weitere erste Laufschaufel A oder dritte Laufschaufel C und eine dieser in Rotationsrichtung nachfolgend benachbarte weitere erste Schaufel A, weitere zweite Laufschaufel B, weitere dritte Laufschaufel C oder vierte Schaufel D aufweisen, insbesondere durch diese gebildet sein, wobei erste, zweite, dritte und vierte Laufschaufeln voneinander verschiedene Schaufelprofile und/oder voneinander verschiedene Schaufelabstände zu in Rotationsrichtung nachfolgend benachbarten Laufschaufeln aufweisen. Dann kann diese Stufe insbesondere die Form (ABCD)(ABCD)(ABCD)... oder (ABAC)(ABAC)(ABAC)... und eine Periodizität bzw. Laufschaufelanzahl P pro Laufschaufelanordnung von 4 aufweisen.

Wie vorstehend ausgeführt, können akustische Beiträge bei Frequenzen entsprechend der Periodizität der Umfangsverteilung der Laufschaufelanordnungen zusätzlich zu den akustischen Beiträgen bei der Blattfolgefrequenz und/oder deren Harmonischen in einem cut-off-Bereich platziert werden. Entsprechend kann in einer Ausführung zusätzlich die Stufe derart ausgelegt werden, dass eine Kenngröße vane-to-blade-ratio, die das Verhältnis von der Leitschaufelanzahl zu der Laufschaufelanzahl der Stufe angibt, in der vorgegebenen Betriebsbedingung der Turbine über einer oberen cut-off Grenze oder unter einer unteren cut-off Grenze für die Mode k=-1, k=-2 und/oder k=-3, insbesondere über einer oberen cut-off Grenze für die Mode k=-1 oder zwischen einer unteren cut-off Grenze für die Mode k=-1 und einer oberen cut-off Grenze für die Mode k=-2, der blade-passing-frequency oder einem ganzzahligen Vielfachen dieser blade-passing-frequency liegt
Gleichermaßen können auch nur diese akustischen Beiträge bei Frequenzen entsprechend der Periodizität der Umfangsverteilung in einem cut-off-Bereich platziert werden. Entsprechend kann in einer Ausführung zusätzlich die Stufe derart ausgelegt werden bzw. sein, dass eine Kenngröße vane-to-blade-ratio, die das Verhältnis von der Leitschaufelanzahl zu der Laufschaufelanzahl der Stufe angibt, in der vorgegebenen Betriebsbedingung der Turbine, entgegen der Lehre des europäischen Patents EP 1 738 061 B1 unter einer oberen cut-off Grenze und über einer unteren cut-off Grenze für die Mode k=-1, k=-2 und/oder k=-3, insbesondere unter einer oberen cut-off Grenze für die Mode k=-1 und über einer unteren cut-off Grenze für die Mode k=-1, k=-2 und/oder k=-3, der blade-passing-frequency liegt.

In einer Ausführung werden bzw. sind ein oder mehrere, insbesondere alle Stufen derart ausgelegt, dass die Kenngröße vane-to-blade-ratio, die das Verhältnis von der Leitschaufelanzahl zu der Laufschaufelanzahl der Stufe angibt, wenigstens im Wesentlichen, gleich eins ist (V/B = 1). Hierdurch kann vorteilhaft zugleich ein von der Turbine abgestrahlter Geräuschpegel und ihre Aerodynamik verbessert werden.

Weitere vorteilhafte Weiterbildungen der vorliegenden Erfindung ergeben sich aus den Unteransprüchen und der nachfolgenden Beschreibung bevorzugter Ausführungen. Hierzu zeigt, teilweise schematisiert:
- Fig. 1: ein Diagramm zur Verdeutlichung einer Auslegung einer Niederdruckturbine nach einer Ausführung der vorliegenden Erfindung;
- Fig. 2: einen Teil eines Laufgitters einer Stufe der Niederdruckturbine der Fig. 1 nach einer Ausführung der vorliegenden Erfindung; und
- Fig. 3: einen Teil eines Laufgitters einer Stufe der Niederdruckturbine der Fig. 1 nach einer Ausführung der vorliegenden Erfindung.

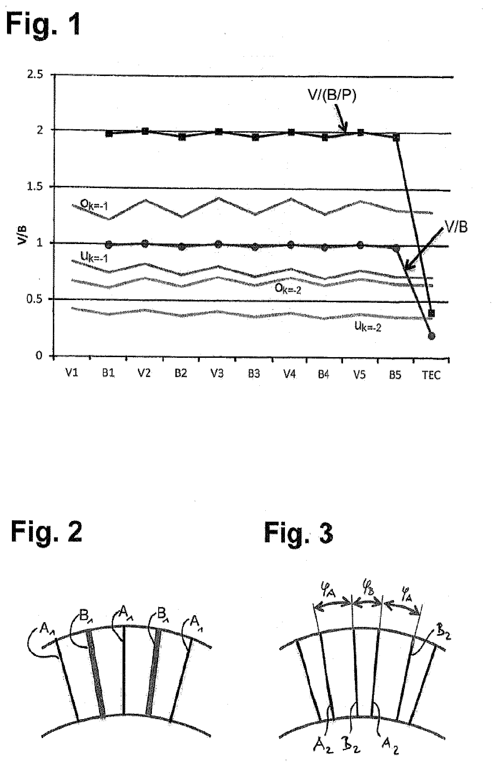

Fig. 1 zeigt in der aus dem europäischen Patent EP 1 738 061 B1 bekannten Weise ein Diagramm zur Verdeutlichung einer Auslegung einer Niederdruckturbine nach einer Ausführung der vorliegenden Erfindung.

Die Niederdruckturbine umfasst mehrere Stufen, die in Durchströmungsrichtung der Niederdruckturbine axial hintereinander angeordnet sind. Jede Stufe wird von einem feststehenden Leitschaufelkranz sowie einem rotierenden Laufschaufelkranz gebildet.

Der Leitschaufelkranz verfügt über mehrere feststehende Leitschaufeln, die auch als Vanes bezeichnet werden. Der rotierende Laufschaufelkranz einer jeden Stufe verfügt über mehrere rotierende Laufschaufeln, die auch als Blades bezeichnet werden.

Fig. 2 zeigt einen Teil des Laufschaufelkranzes einer Stufe der Niederdruckturbine mit einer Mehrzahl von Laufschaufelanordnungen (AiBi)(AiBi)..., die jeweils von zwei Laufschaufeln A₁, B₁ mit voneinander verschiedenen Schaufelprofilen gebildet sind.

Fig. 3 zeigt einen Teil des Laufschaufelkranzes einer Stufe der Niederdruckturbine mit einer Mehrzahl von Laufschaufelanordnungen (A₂B₂)(A₂B₂)..., die jeweils von zwei Laufschaufeln A₂, B₂ mit gleichen Schaufelprofilen und voneinander verschiedenen Schaufelabständen ϕ_{A}, ϕ_{B} zu in Rotationsrichtung nachfolgend benachbarten Laufschaufeln gebildet sind.

Diese Stufen sind durch eine Kenngröße vane-to-blade-cluster-ratio V/(B/P) charakterisiert, die das Verhältnis von der Leitschaufelanzahl V der Stufe zu dem Quotienten (B/P) der Laufschaufelanzahl (B) der Stufe dividiert durch die Laufschaufelanzahl P=2 pro Laufschaufelanordnung angibt und in Fig. 1 angedeutet ist.

Diese Stufen werden bzw. sind derart ausgelegt, dass diese Kenngröße vane-to-blade-cluster-ratio in einer lärmkritischen Betriebsbedingung der Turbine über einer oberen cut-off Grenze für die Mode k=-1 oder zwischen einer unteren cut-off Grenze für die Mode k=-1 und über einer oberen cut-off Grenze für die Mode k=-2 bei einer Frequenz gebildet durch das Verhältnis der blade-passing-frequency zu der Laufschaufelanzahl pro Laufschaufelanordnung oder einem ganzzahligen Vielfachen dieses Verhältnisses liegt, so dass die Niederdruckturbine einen möglichst geringen Lärmpegel bzw. Geräuschpegel bei solchen lärmkritischen Betriebsbedingungen abstrahlt. Bei solchen lärmkritischen Betriebsbedingungen handelt es sich z. B. um einen Start oder Landeanflug eines Flugzeugs oder um ein Rollen des Flugzeugs auf einem Rollfeld eines Flughafens.

Zusätzlich sind in Fig. 1 das vane-to-blade-ratio (V/B) sowie eine obere und untere cut-off Grenze oₖ₌₋₁ bzw. uₖ₌₋₁ für die Mode k = -1 der blade-passing-frequency und eine obere und untere cut-off Grenze oₖ₌₋₂ bzw. uₖ₌₋₂ für die Mode k = -2 der blade-passing-frequency (BPF) der jeweiligen Stufe eingezeichnet. In dem Diagramm sind fünf Stufen bzw. deren Leitschaufelkränze V1 bis V5 sowie Laufschaufelkränze B1 bis B5 und das Turbinenaustrittsgehäuse TEC aufgetragen.

Man erkennt, dass das vane-to-blade-ratio (V/B), das das Verhältnis von der Leitschaufelanzahl zu Laufschaufelanzahl der Stufe angibt, in der lärmkritischen Betriebsbedingung der Turbine unter der oberen cut-off Grenze oₖ₌₋₁ und über der unteren cut-off Grenze uₖ₌₋₁ für die Mode k=-1 der blade-passing-frequency liegt. Das vane-to-blade-cluster-ratio V/(B/P) liegt über der oberen cut-off Grenze oₖ₌₋₁.

Obwohl in der vorhergehenden Beschreibung exemplarische Ausführungen erläutert wurden, sei darauf hingewiesen, dass eine Vielzahl von Abwandlungen möglich ist. Außerdem sei darauf hingewiesen, dass es sich bei den exemplarischen Ausführungen lediglich um Beispiele handelt, die den Schutzbereich, die Anwendungen und den Aufbau in keiner Weise einschränken sollen. Vielmehr wird dem Fachmann durch die vorausgehende Beschreibung ein Leitfaden für die Umsetzung von mindestens einer exemplarischen Ausführung gegeben, wobei diverse Änderungen, insbesondere in Hinblick auf die Funktion und Anordnung der beschriebenen Bestandteile, vorgenommen werden können, ohne den Schutzbereich zu verlassen, wie er sich aus den Ansprüchen und diesen äquivalenten Merkmalskombinationen ergibt.

### Bezugszeichenliste

- A₁, B₁; A₂; B₂: Laufschaufeln
- B: Laufschaufelanzahl
- ϕ_{A}, ϕ_{B}: Schaufelabstände
- V/(B/P): vane-to-blade-cluster-ratio
- V: Leitschaufelanzahl
- P: Periodizität
- oₖ₌₋₁, oₖ₌₋₂: obere cut-off Grenze
- uₖ₌₋₁, uₖ₌₋₂: untere cut-off Grenze

## Patentansprüche

1. Verfahren zum Auslegen einer Turbine, insbesondere einer Niederdruckturbine, einer Gasturbine, insbesondere eines Flugtriebwerks, mit mehreren in Durchströmungsrichtung der Turbine axial hintereinander angeordneten Stufen, die jeweils von einem feststehenden, mehrere Leitschaufeln aufweisenden Leitgitter und einem rotierenden, mehrere Laufschaufeln aufweisenden Laufgitter gebildet sind;
**dadurch gekennzeichnet, dass**
das Laufgitter wenigstens einer dieser Stufen eine Mehrzahl von Laufschaufelanordnungen aufweist, die jeweils von wenigstens zwei Laufschaufeln (A₁, B₁; A₂, B₂) mit voneinander verschiedenen Schaufelprofilen und/oder voneinander verschiedenen Schaufelabständen (ϕ_{A}, ϕ_{B}) zu in Rotationsrichtung nachfolgend benachbarten Laufschaufeln gebildet sind;
diese Stufe durch eine Kenngröße vane-to-blade-cluster-ratio (V/(B/P)) charakterisiert ist, die das Verhältnis von der Leitschaufelanzahl (V) zu dem Quotienten (B/P) der Laufschaufelanzahl (B) der Stufe dividiert durch die Laufschaufelanzahl pro Laufschaufelanordnung (P) angibt; und
diese Stufe derart ausgelegt wird, dass diese Kenngröße vane-to-blade-cluster-ratio in einer vorgegebenen Betriebsbedingung der Turbine über einer oberen cut-off Grenze für die Mode k=-1 oder zwischen einer unteren cut-off Grenze für die Mode k=-1 und einer oberen cut-off Grenze für die Mode k=-2 einer Frequenz gebildet durch ein Verhältnis der blade-passing-frequency zu der Laufschaufelanzahl pro Laufschaufelanordnung oder einem ganzzahligen Vielfachen dieses Verhältnisses liegt.

2. Verfahren nach dem vorhergehenden Anspruch, **dadurch gekennzeichnet, dass** das Laufgitter dieser Stufen von der Mehrzahl von Laufschaufelanordnungen gebildet ist.

3. Verfahren nach einem der vorhergehenden Ansprüche, **dadurch gekennzeichnet, dass** die Laufschaufelanordnungen dieser Stufe untereinander gleich sind.

4. Verfahren nach einem der vorhergehenden Ansprüche, **dadurch gekennzeichnet, dass** die Laufschaufelanordnungen dieser Stufe jeweils von genau zwei oder von wenigstens oder genau drei, insbesondere wenigstens oder genau vier, Laufschaufeln gebildet sind, wobei wenigstens zwei Laufschaufeln einer Laufschaufelanordnung voneinander verschiedene Schaufelprofile und/oder voneinander verschiedene Schaufelabstände zu in Rotationsrichtung nachfolgend benachbarten Laufschaufeln aufweisen.

5. Verfahren nach einem der vorhergehenden Ansprüche, **dadurch gekennzeichnet, dass** die Laufschaufelanordnungen dieser Stufe jeweils eine erste Schaufel, eine dieser in Rotationsrichtung nachfolgend benachbarte zweite Laufschaufel und eine dieser in Rotationsrichtung nachfolgend benachbarte weitere erste oder dritte Laufschaufel aufweist, wobei erste, zweite und dritte Laufschaufeln voneinander verschiedene Schaufelprofile und/oder voneinander verschiedene Schaufelabstände zu in Rotationsrichtung nachfolgend benachbarten Laufschaufeln aufweisen.

6. Verfahren nach einem der vorhergehenden Ansprüche, **dadurch gekennzeichnet, dass** diese Stufe eine in Durchströmungsrichtung stromaufwärts vor einer weiteren Stufe angeordnete, insbesondere erste, Stufe oder eine in Durchströmungsrichtung stromabwärts nach einer weiteren Stufe angeordnete, insbesondere letzte, Stufe der Turbine ist.

7. Verfahren nach einem der vorhergehenden Ansprüche, **dadurch gekennzeichnet, dass** die voneinander verschiedenen Schaufelprofile unterschiedliche Profildicken, Profildicken-, Twist- und/oder Staffelungsverteilungen und/oder Profiltypen aufweisen.

8. Verfahren nach einem der vorhergehenden Ansprüche, **dadurch gekennzeichnet, dass** diese Stufe derart ausgelegt wird, dass eine Kenngröße vane-to-blade-ratio, die das Verhältnis von der Leitschaufelanzahl zu Laufschaufelanzahl der Stufe angibt, in der vorgegebenen Betriebsbedingung der Turbine unter einer oberen cut-off Grenze (oₖ₌₋₁, oₖ₌₋₂) und über einer unteren cut-off Grenze (uₖ₌₋₁, uₖ₌₋₂) für die Mode k=-1, k=-2 und/oder k=-3, insbesondere unter einer oberen cut-off Grenze für die Mode k=-1 und über einer oberen cut-off Grenze für die Mode k=-1, k=-2 und/oder k=-3, der blade-passing-frequency liegt.

9. Turbine, insbesondere Niederdruckturbine, einer Gasturbine, insbesondere eines Flugtriebwerks, mit mehreren in Durchströmungsrichtung der Turbine axial hintereinander angeordneten Stufen, die jeweils von einem feststehenden, mehrere Leitschaufeln aufweisenden Leitgitter und einem rotierenden, mehrere Laufschaufeln aufweisenden Laufgitter gebildet sind;
**dadurch gekennzeichnet, dass**
das Laufgitter wenigstens der in Durchströmungsrichtung letzten Stufe der Turbine eine Mehrzahl von Laufschaufelanordnungen aufweist, die jeweils von wenigstens zwei Laufschaufeln (A₁, B₁; A₂; B₂) mit voneinander verschiedenen Schaufelprofilen und/oder voneinander verschiedenen Schaufelabständen (ϕ_{A}, ϕ_{B}) zu in Rotationsrichtung nachfolgend benachbarten Laufschaufeln gebildet sind;
diese letzte Stufe durch eine Kenngröße vane-to-blade-cluster-ratio (V/(B/P)) charakterisiert ist, die das Verhältnis von der Leitschaufelanzahl (V) zu dem Quotienten (B/P) der Laufschaufelanzahl (B) der Stufe dividiert durch die Laufschaufelanzahl pro Laufschaufelanordnung (P) angibt; und
diese letzte Stufe derart ausgelegt ist, dass diese Kenngröße vane-to-blade-cluster-ratio in einer vorgegebenen Betriebsbedingung der Turbine über einer oberen cut-off Grenze für die Mode k=-1 oder zwischen einer unteren cut-off Grenze für die Mode k=-1 und einer oberen cut-off Grenze für die Mode k=-2, einer Frequenz gebildet durch ein Verhältnis der blade-passing-frequency zu der Laufschaufelanzahl pro Laufschaufelanordnung oder einem ganzzahligen Vielfachen dieses Verhältnisses liegt und dass eine Kenngröße vane-to-blade-ratio, die das Verhältnis von der Leitschaufelanzahl zu Laufschaufelanzahl der Stufe angibt, in der vorgegebenen Betriebsbedingung der Turbine unter einer oberen cut-off Grenze (oₖ₌₋₁) für die Mode k=-1 und über einer unteren cut-off Grenze (uₖ₌₋₃) für die Mode k=-3 der blade-passing-frequency liegt.

10. Turbine nach dem vorhergehenden Anspruch, **dadurch gekennzeichnet, dass** das Laufgitter der letzten Stufe von der Mehrzahl von Laufschaufelanordnungen gebildet ist.

11. Turbine nach einem der vorhergehenden Ansprüche, **dadurch gekennzeichnet, dass** die Laufschaufelanordnungen der letzten Stufe untereinander gleich sind.

12. Turbine nach einem der vorhergehenden Ansprüche, **dadurch gekennzeichnet, dass** die Laufschaufelanordnungen der letzten Stufe jeweils von genau zwei oder von wenigstens oder genau drei, insbesondere wenigstens oder genau vier, Laufschaufeln gebildet sind, wobei wenigstens zwei Laufschaufeln einer Laufschaufelanordnung voneinander verschiedene Schaufelprofile und/oder voneinander verschiedene Schaufelabstände zu in Rotationsrichtung nachfolgend benachbarten Laufschaufeln aufweisen.

13. Turbine nach einem der vorhergehenden Ansprüche, **dadurch gekennzeichnet, dass** die Laufschaufelanordnungen dier letzten Stufe jeweils eine erste Schaufel, eine dieser in Rotationsrichtung nachfolgend benachbarte zweite Laufschaufel und eine dieser in Rotationsrichtung nachfolgend benachbarte weitere erste oder dritte Laufschaufel aufweist, wobei erste, zweite und dritte Laufschaufeln voneinander verschiedene Schaufelprofile und/oder voneinander verschiedene Schaufelabstände zu in Rotationsrichtung nachfolgend benachbarten Laufschaufeln aufweisen.

## Claims

1. Method for designing a tur
bine, in particular a low-pressure turbine, of a gas turbine, in particular an aircraft engine,
comprising a plurality of stages arranged axially behind one another in the flow direction of the turbine, which stages are each formed by a fixed guide baffle having a plurality of guide vanes and by a rotating rotor cascade having a plurality of rotor blades;
**characterized in that** the rotor cascade of at least one of said stages has a plurality of rotor blade arrangements which are each formed by at least two rotor blades (A₁, B₁; A₂, B₂) having mutually different blade profiles and/or mutually different blade spacings (ϕ_{A}, ϕ_{B}) to rotor blades which are subsequently adjacent in the direction of rotation;
this stage is **characterized by** a vane-to-blade-cluster ratio (V/(B/P)) parameter that indicates the ratio of the number of guide vanes (V) to the quotient (B/P) of the number of rotor blades (B) of the stage divided by the number of rotor blades per rotor blade arrangement (P); and
this stage is designed such that, in a predetermined operating condition of the turbine, said vane-to-blade-cluster ratio parameter is above an upper cut-off limit for the mode k=-1 or is between a lower cut-off limit for the mode k=-1 and an upper cut-off limit for the mode k=-2 of a frequency formed by a ratio of the blade passing frequency to the number of rotor blades per rotor blade arrangement or to an integer multiple of said ratio.

2. Method according to the preceding claim, **characterized in that** the rotor cascade of said stages is formed by the plurality of rotor blade arrangements.

3. Method according to either of the preceding claims, **characterized in that** the rotor blade arrangements of said stage are identical to one another.

4. Method according to any of the preceding claims, **characterized in that** the rotor blade arrangements of said stage are each formed by exactly two or at least or exactly three, in particular at least or exactly four, rotor blades, at least two rotor blades of a rotor blade arrangement having mutually different blade profiles and/or mutually different blade spacings to rotor blades which are subsequently adjacent in the direction of rotation.

5. Method according to any of the preceding claims, **characterized in that** the rotor blade arrangements of said stage each have a first blade, a second rotor blade which is subsequently adjacent thereto in the direction of rotation, and a further first or third rotor blade which is subsequently adjacent to the second rotor blade in the direction of rotation, first, second and third rotor blades having mutually different blade profiles and/or mutually different blade spacings to rotor blades which are subsequently adjacent in the direction of rotation.

6. Method according to any of the preceding claims, **characterized in that** said stage is a stage, in particular a first stage, of the turbine that is arranged upstream of a further stage in the flow direction, or is a stage, in particular a last stage, of the turbine that is arranged downstream of a further stage in the flow direction.

7. Method according to any of the preceding claims, **characterized in that** the mutually different blade profiles have different profile thicknesses, profile thickness distributions, twist distributions and/or graduation distributions and/or profile types.

8. Method according to any of the preceding claims, **characterized in that** this stage is designed such that, in the predetermined operating condition of the turbine, a vane-to-blade ratio parameter which indicates the ratio of the number of guide vanes to the number of rotor blades of the stage is below an upper cut-off limit (oₖ₌₋₁, oₖ₌₋₂) and above a lower cut-off limit (uₖ₌₋₁, uₖ₌₋₂) for the mode k=-1, k=-2 and/or k=-3, in particular below an upper cut-off limit for the mode k=-1 and above an upper cut-off limit for the mode k=-1, k=-2 and/or k=-3, of the blade passing frequency.

9. Turbine, in particular a low-pressure turbine, of a gas turbine, in particular an aircraft engine, comprising a plurality of stages arranged axially behind one another in the flow direction of the turbine, which stages are each formed by a fixed guide baffle having a plurality of guide vanes and by a rotating rotor cascade having a plurality of rotor blades;
**characterized in that** the rotor cascade of at least the last stage of the turbine in the flow direction has a plurality of rotor blade arrangements which are each formed by at least two rotor blades (A₁, B₁; A₂, B₂) having mutually different blade profiles and/or mutually different blade spacings (ϕ_{A}, ϕ_{B}) to rotor blades which are subsequently adjacent in the direction of rotation;
this last stage is **characterized by** a vane-to-blade-cluster ratio (V/(B/P)) parameter that indicates the ratio of the number of guide vanes (V) to the quotient (B/P) of the number of rotor blades (B) of the stage divided by the number of rotor blades per rotor blade arrangement (P); and
this last stage is designed such that, in a predetermined operating condition of the turbine, said vane-to-blade-cluster ratio parameter is above an upper cut-off limit for the mode k=-1 or is between a lower cut-off limit for the mode k=-1 and an upper cut-off limit for the mode k=-2 of a frequency formed by a ratio of the blade passing frequency to the number of rotor blades per rotor blade arrangement or to an integer multiple of said ratio, and that, in the predetermined operating condition of the turbine, a vane-to-blade ratio parameter which indicates the ratio of the number of guide vanes to the number of rotor blades of the stage is below an upper cut-off limit (oₖ₌₋₁) for the mode k=-1 and above a lower cut-off limit (uₖ₌₋₃) for the mode k=-3 of the blade passing frequency.

10. Turbine according to the preceding claim, **characterized in that** the rotor cascade of the last stage is formed by the plurality of rotor blade arrangements.

11. Turbine according to any of the preceding claims, **characterized in that** the rotor blade arrangements of the last stage are identical to one another.

12. Turbine according to any of the preceding claims, **characterized in that** the rotor blade arrangements of the last stage are each formed by exactly two or at least or exactly three, in particular at least or exactly four, rotor blades, at least two rotor blades of a rotor blade arrangement having mutually different blade profiles and/or mutually different blade spacings to rotor blades which are subsequently adjacent in the direction of rotation.

13. Turbine according to any of the preceding claims, **characterized in that** the rotor blade arrangements of the last stage each have a first blade, a second rotor blade which is subsequently adjacent thereto in the direction of rotation, and a further first or third rotor blade which is subsequently adjacent to the second rotor blade in the direction of rotation, first, second and third rotor blades having mutually different blade profiles and/or mutually different blade spacings to rotor blades which are subsequently adjacent in the direction of rotation.

## Revendications

1. Procédé de conception d'une turbine, en particulier d'une turbine basse pression, d'une turbine à gaz, en particulier d'un moteur d'avion, comportant plusieurs étages disposés axialement les uns derrière les autres dans le sens d'écoulement de la turbine, lesquels étages sont chacun formés par une grille de guidage fixe comportant plusieurs aubes directrices et une grille mobile rotative comportant plusieurs aubes mobiles ;
**caractérisé en ce que** la grille de guidage d'au moins l'un desdits étages comprend une pluralité d'ensembles de lames formés chacun par au moins deux aubes mobiles (A₁, B₁ ; A₂, B₂) ayant des profils d'aube différents les uns des autres et/ou des espacements d'aube (ϕ_{A}, ϕ_{B}) différents les uns des autres et par rapport à des aubes mobiles adjacentes se suivant dans le sens de rotation ;
ledit étage est **caractérisé par** un paramètre de rapport ailette à ensemble d'aubes (V/(B/P)) indiquant le rapport entre le nombre d'aubes directrices (V) et le quotient (B/P) du nombre d'aubes mobiles (B) de l'étage divisé par le nombre d'aubes mobiles par ensemble d'aubes mobiles (P) ; et
ledit étage est conçu de sorte que ledit rapport ailette à ensemble d'aubes dans un état de fonctionnement prédéterminé de la turbine est supérieur à une limite supérieure de coupure pour le mode k = -1 ou entre une limite inférieure de coupure pour le mode k = -1 et une limite supérieure de coupure pour le mode k = -2 d'une fréquence formée par un rapport entre la fréquence de passage d'aube et le nombre d'aubes mobiles par ensemble d'aubes mobiles ou un multiple entier dudit rapport.

2. Procédé selon la revendication précédente, **caractérisé en ce que** les grilles mobiles desdits étages sont formés par la pluralité d'ensembles d'aubes mobiles.

3. Procédé selon l'une quelconque des revendications précédentes, **caractérisé en ce que** les ensembles d'aubes mobiles dudit étage sont identiques les uns aux autres.

4. Procédé selon l'une quelconque des revendications précédentes, **caractérisé en ce que** les ensembles d'aubes mobiles dudit étage sont formés chacun par exactement deux ou par au moins ou exactement trois, en particulier au moins ou exactement quatre aubes mobiles, dans lequel au moins deux aubes mobiles d'un ensemble d'aubes mobiles présentent, dans le sens de rotation, des profils d'aube différents les uns des autres et/ou des espacements d'aubes différents les uns des autres par rapport à des aubes mobiles adjacentes se suivant dans le sens de rotation.

5. Procédé selon l'une quelconque des revendications précédentes, **caractérisé en ce que** les ensembles d'aubes mobiles dudit étage présentent chacun une première aube, une deuxième aube mobile adjacente suivant la première aube dans le sens de rotation et une autre première ou troisième aube mobile adjacente suivant la deuxième aube mobile dans le sens de rotation, les première, deuxième et troisième aubes mobiles présentant, dans le sens de rotation, des profils d'aube différents les uns des autres et/ou des espacements d'aube mob différents les uns des autres par rapport à des aubes mobiles adjacentes se suivant dans le sens de rotation.

6. Procédé selon l'une quelconque des revendications précédentes, **caractérisé en ce que** ledit étage est un étage, en particulier un premier étage, disposé en amont dans le sens d'écoulement avant un autre étage, ou un étage, en particulier un dernier étage, de la turbine, disposé en aval dans le sens d'écoulement après un autre étage.

7. Procédé selon l'une quelconque des revendications précédentes, **caractérisé en ce que** les profils d'aube qui diffèrent les uns des autres ont des épaisseurs de profil, des distributions d'épaisseur de profil, des distributions de torsion et/ou des distributions de graduation et/ou des types de profil différents.

8. Procédé selon l'une quelconque des revendications précédentes, **caractérisé en ce que** ledit étage est conçu de sorte qu'un paramètre de rapport ailette à aube, qui indique le rapport entre le nombre d'aubes directrices et le nombre d'aubes mobiles de l'étage, dans l'état de fonctionnement prédéterminé de la turbine sous une limite supérieure de coupure (oₖ=-1, oₖ=-2) et au-dessus d'une limite inférieure de coupure (uₖ=-1, uₖ=-2) pour le mode k=-1, k=-2 et/ou k=-3, en particulier en dessous d'une limite supérieure de coupure pour le mode k=-1 et au-dessus d'une limite supérieure de coupure pour le mode k=-1, k=-2 et/ou k=-3, de la fréquence de passage d'aube.

9. Turbine, en particulier turbine à basse pression, d'une turbine à gaz, en particulier d'un moteur d'aéronef, avec une pluralité d'étages disposés axialement les uns derrière les autres dans le sens d'écoulement de la turbine, lesquels étages sont chacun formés par une grille de guidage fixe présentant plusieurs aubes directrices et une grille mobile rotative présentant plusieurs aubes mobiles ;
**caractérisé en ce que** la grille mobile comporte au moins une pluralité d'ensembles d'aubes directrices au dernier étage de la turbine dans le sens d'écoulement, lesquels ensembles sont formés chacun par au moins deux aubes mobiles (A₁, B₁ ; A₂, B₂) ayant des profils d'aubes différents les uns des autres et/ou des espacements d'aubes (ϕ_{A}, ϕ_{B}) différents les uns des autres par rapport à des aubes mobiles adjacentes se suivant dans le sens de rotation ;
ledit dernier étage est **caractérisé par** un paramètre de rapport ailette à ensemble d'aubes (V/(B/P)) indiquant le rapport entre le nombre d'aubes directrices (V) et le quotient (B/P) du nombre d'aubes mobiles (B) de l'étage divisé par le nombre d'aubes mobiles par ensemble d'aubes mobiles (P) ; et
ledit dernier étage est conçu de sorte que ledit paramètre de rapport ailettes à ensemble d'aubes dans une condition de fonctionnement donnée de la turbine se trouve au-dessus d'une limite supérieure de coupure pour le mode k=-1 ou entre une limite inférieure de coupure pour le mode k=-1 et une limite supérieure de coupure pour le mode k=-2, d'une fréquence formée par un rapport entre la fréquence de passage d'aube et le nombre d'aubes mobiles par ensemble d'aubes mobiles ou un multiple entier dudit rapport, et qu'un paramètre de rapport ailette à aube indiquant le rapport entre le nombre d'aubes directrices et le nombre d'aubes mobiles de l'étage, dans les conditions de fonctionnement données de la turbine, se trouve au-dessous d'une limite supérieure de coupure (oₖ₌₋₁) pour le mode k=-1 et au-dessus d'une limite inférieure de coupure (uₖ₌₋₃) pour le mode k=-3 de la fréquence de passage d'aube.

10. Turbine selon la revendication précédente, **caractérisée en ce que** la grille mobile du dernier étage est formée par la pluralité d'ensembles d'aubes mobiles.

11. Turbine selon l'une quelconque des revendications précédentes, **caractérisée en ce que** les ensembles d'aubes mobiles du dernier étage sont égaux les uns aux autres.

12. Turbine selon l'une quelconque des revendications précédentes, **caractérisée en ce que** les ensembles d'aubes mobiles du dernier étage sont formés chacun par exactement deux ou par au moins ou exactement trois, en particulier au moins ou exactement quatre, aubes mobiles, au moins deux aubes mobiles d'un ensemble d'aubes mobiles présentant des profils d'aube différents les uns des autres et/ou des espacements d'aube par rapport à des aubes mobiles adjacentes se suivant dans le sens de rotation.

13. Turbine selon l'une quelconque des revendications précédentes, **caractérisée en ce que** les ensembles d'aubes mobiles du dernier étage présentent chacun une première aube, une deuxième aube mobile adjacente suivant la première aube dans le sens de rotation et une autre première ou troisième aube mobile adjacente suivant la deuxième aube dans le sens de rotation, les première, deuxième et troisième aubes mobiles présentant, dans le sens de rotation, des profils d'aube différents les uns des autres et/ou des espacements d'aube différents les uns des autres par rapport à des aubes mobiles adjacentes se suivant dans le sens de rotation.
